# EUROPEAN PATENT APPLICATION

(11) **EP 3 163 987 A1**
(43) Date of publication of application: **03.05.2017**
(21) Application number: 14896167.5
(22) Date of filing: 17.09.2014
(51) Int. Cl.: H05K 7/20

(54) **NOISE REDUCTION APPARATUS AND METHOD**

(30) Priority: 26.06.2014 CN 201410294987
(71) Applicant: ZTE Corporation, Shenzhen, Guangdong 518057 (CN)
(72) Inventor: LU, Yao, Shenzhen Guangdong 518057 (CN); LIANG, Qi, Shenzhen Guangdong 518057 (CN); LI, Shuai, Shenzhen Guangdong 518057 (CN); YANG, Lilong, Shenzhen Guangdong 518057 (CN)
(74) Representative: Savi, Massimiliano
(86) International application number: PCT/CN2014/086754
(87) International publication number: WO 2015/196588

(57) **Abstract**

The present invention discloses a noise reduction apparatus and method. Herein, the noise reduction apparatus includes a flow deflector. The flow deflector is provided above a first ventilation opening on a front door of a cabinet. The flow deflector is further provided thereon with a second ventilation opening corresponding to the first ventilation opening. The flow deflector cooperates with the front door of the cabinet to form a wind flow channel of the first ventilation opening. The ventilation openings are ventilation openings of a heat dissipation device in the cabinet. The wind flow channel is provided therein with an acoustic absorption material.

## Description

### Technical Field

The present invention relates to the technical field of communications, and more particularly to a noise reduction apparatus and method.

### Background

Noise control of communication products is a problem needing to be considered from design development to engineering application. Noise control of an outdoor cabinet is a system problem, strongly correlated to thermal design and restricted by multiple factors such as product size, architecture and heat consumption and so on.

Currently, heat dissipation modes mainly applied to outdoor cabinets include a direct-ventilation, a heat-exchanger, a Thermoelectric Cooler TEC air conditioner, and a compressor air conditioner and so on. One of common integrated cabinets is provided therein with a device compartment for mounting a device as well as a battery compartment for accommodating a battery. The device compartment adopts the heat exchanger to dissipate heat, and the battery compartment adopts the TEC air conditioner to dissipate heat. The outdoor cabinet with that layout can satisfy an integrated device-battery layout, and can provide a closed internal environment, and is greatly demanded in some high-temperature environments and environments having higher anti-corrosion requirements. However, at present, noise data of the outdoor cabinet with that layout stays at a high level, and cannot meet higher use demands.

The main reason is that: on one hand, power of the device in the cabinet is more and more higher, and the heating quantity is higher, and an internal and external circulating fan of a heat exchanger usually runs at a full speed, which causes noise generation. Meanwhile, noise generated by running of a TEC air conditioner fan is greater. Superposition of the noise of the heat exchanger and the TEC air conditioner cannot meet use requirements. In addition, under the restriction of comprehensive factors of architecture, space, cost and heat loss of cabinet products, reduction of the noise of the outdoor integrated cabinet becomes a problem. A current customer-defmed noise index requirement for an outdoor product is increasingly improved, gradually from an original city-level index demand to a country-level index demand. An existing noise reduction method for an integrated cabinet, particularly noise control of a TEC air conditioner in the integrated cabinet, cannot meet use requirements.

### Summary of the Invention

Embodiments of the present invention provide a noise reduction apparatus and method, which can solve the problem that the noise of an outdoor cabinet with a heat dissipation device cannot be effectively reduced currently.

According to the first aspect, an embodiment of the present invention provides a noise reduction apparatus, which includes a flow deflector. The flow deflector is provided above a first ventilation opening on a front door of a cabinet. The flow deflector is further provided thereon with a second ventilation opening corresponding to the first ventilation opening. The flow deflector cooperates with the front door of the cabinet to form a wind flow channel of the first ventilation opening. The ventilation openings are ventilation openings of a heat dissipation device in the cabinet. The wind flow channel is provided therein with an acoustic absorption material.

In an exemplary embodiment, the flow deflector includes a cover body, and the cover body is provided above the first ventilation opening, and the cover body is provided with the second ventilation opening corresponding to the first ventilation opening, and the cover body cooperates with the front door of the cabinet to form a cavity; and the first ventilation opening, the second ventilation opening and the cavity form a wind flow channel of the ventilation openings, and an inner side surface of the cover body is provided with an acoustic absorption material.

In an exemplary embodiment, the first ventilation opening includes a first wind outlet of a first heat dissipation device; the cover body is provided with a second wind outlet corresponding to the first wind outlet, and the first wind outlet, the second wind outlet and the cavity form an outlet wind flow channel of the first wind outlet.

In another exemplary embodiment, the first ventilation opening includes a first wind inlet of the first heat dissipation device; the cover body is provided with a second wind inlet corresponding to the first wind inlet; and the first wind inlet, the second wind inlet and the cavity form an inlet wind flow channel of the first wind inlet.

In still another exemplary embodiment, the first ventilation opening includes the first wind inlet and first wind outlet of the first heat dissipation device; the cover body is provided with the second wind inlet corresponding to the first wind inlet, and the second wind inlet corresponding to the first wind inlet; the first wind inlet, the second wind inlet and the cavity form an inlet wind flow channel of the first wind inlet; and the first wind outlet, the second wind outlet and the cavity form the inlet wind flow channel of the first wind inlet.

In an exemplary embodiment, the first ventilation opening includes a first ventilation opening of the first heat dissipation device and a first ventilation opening of a second heat dissipation device; the cover body includes a first cover body and a second cover body; the first cover body is provided above the first ventilation opening of the first heat dissipation device, and the first cover body is provided with a second ventilation opening corresponding to the first ventilation opening of the first heat dissipation device, and the first cover body and the front door of the cabinet form a first cavity; the first ventilation opening of the first heat dissipation device, the second ventilation opening on the first cover body and the first cavity form a wind flow channel of the first ventilation opening of the first heat dissipation device, and an inner side of the first cover body is provided with an acoustic absorption material.

The second cover body is provided above the first ventilation opening of the second heat dissipation device, and the second cover body is provided with a second ventilation opening corresponding to the first ventilation opening of the second heat dissipation device, and the second cover body and the front door of the cabinet form a second cavity; and the first ventilation opening of the second heat dissipation device, the second ventilation opening on the second cover body and the second cavity form a wind flow channel of the first ventilation opening of the second heat dissipation device.

In an exemplary embodiment, the first ventilation opening includes: a first wind outlet and first wind inlet of the first heat dissipation device, and a ventilation opening of the second heat dissipation device; the cover body includes a first cover body and a second cover body; the first cover body is provided above the first wind inlet, and forms a first cavity with the front door of the cabinet, and the first cover body is provided with a second wind inlet corresponding to the first wind inlet; and the first wind inlet, the second wind inlet and the first cavity form an inlet wind flow channel of the first wind inlet.

The second cover body is provided above the first wind outlet and the ventilation opening of the second heat dissipation device, and the second cover body and the front door of the cabinet form a second cavity, and the second cover body is provided with a ventilation opening corresponding to the first wind outlet and the ventilation opening of the second heat dissipation device; and the first wind outlet, the second cavity and the ventilation opening on the second cover body form an inlet wind flow channel of the first wind outlet, and the ventilation opening of the second heat dissipation device, the second cavity and the ventilation opening on the second cover body form a wind flow channel of the ventilation opening of the second heat dissipation device.

In an exemplary embodiment, the first ventilation opening includes: a first wind outlet and first wind inlet of the first heat dissipation device, and a ventilation opening of the second heat dissipation device; the cover body includes a first cover body and a second cover body; the first cover body is provided above the first wind outlet, and forms a first cavity with the front door of the cabinet, and the first cover body is provided with a second wind outlet corresponding to the first wind outlet; the first wind outlet, the second wind outlet and the first cavity form an outlet wind flow channel of the first wind outlet.

The second cover body is provided above the first wind inlet and the ventilation opening of the second heat dissipation device, and the second cover body and the front door of the cabinet form a second cavity, and the second cover body is provided with a ventilation opening corresponding to the first wind inlet and the ventilation opening of the second heat dissipation device; and the first wind inlet, the second cavity and the ventilation opening on the second cover body form an inlet wind flow channel of the first wind inlet, and the ventilation opening of the second heat dissipation device, the second cavity and the ventilation opening of the second cover body form a wind flow channel of the ventilation opening of the second heat dissipation device.

In an exemplary embodiment, the cover body further includes an isolator located in the second cover body, and the isolator is provided above the ventilation opening of the second heat dissipation device and isolates the second cavity into two cavities, i.e., an internal cavity and an external cavity, and the ventilation opening of the second heat dissipation device is located in the internal cavity, and the first wind inlet of the first heat dissipation device is located in the external cavity; the second cover body is provided with a second wind inlet corresponding to the first wind inlet, and a second ventilation opening corresponding to the ventilation opening of the second heat dissipation device.

The first wind inlet, the external cavity and the second wind inlet of the second cover body form an inlet wind flow channel of the first wind inlet.

The ventilation opening of the second heat dissipation device, the internal cavity and the ventilation opening, corresponding to the ventilation opening of the second heat dissipation device, on the second cover body form a wind flow channel of the ventilation opening of the second heat dissipation device; and the inner side of the internal cavity is provided with an acoustic absorption material.

In an exemplary embodiment, the ventilation opening of the second heat dissipation device includes: an inlet wind fan opening of an air conditioner and a wind outlet of the air conditioner; the isolator is a supporter, and the supporter cooperates with the inlet wind fan opening to isolate the second cavity into two cavities, i.e., an internal cavity and an external cavity; the first wind inlet is located in the external cavity, and the wind outlet of the air conditioner is located in the internal cavity, and the inlet wind fan opening is located at the top of the internal cavity; the second cover body is provided with a second wind inlet corresponding to the first wind inlet and the inlet wind fan opening, and the second cover body is further provided with a second wind outlet corresponding to the wind outlet of the air conditioner.

The first wind inlet, the external cavity and the second wind inlet of the second cover body form an inlet wind flow channel of the first wind inlet.

The inlet wind fan opening, the external cavity and the second wind inlet of the second cover body form an inlet wind flow channel of the inlet wind fan opening.

The wind outlet of the air conditioner, the internal cavity and the second wind outlet of the second cover body form an outlet wind flow channel of the wind outlet of the air conditioner; and an inner side of the supporter is provided with an acoustic absorption material.

In an exemplary embodiment, the wind outlet of the air conditioner includes: an upper wind outlet and a lower wind outlet; the flow deflector further includes: an isolating sheet; the isolating sheet is located in the internal cavity and cooperates with the air conditioner to isolate the internal cavity into a first internal cavity and a second internal cavity; the upper wind outlet is located in the first internal cavity, and the lower wind outlet is located in the second internal cavity; the second cover body is provided with a second upper wind outlet corresponding to the upper wind outlet and a second lower wind outlet corresponding to the lower wind outlet.

The upper wind outlet of the air conditioner, the first internal cavity and the second upper wind outlet form an outlet wind flow channel of the upper wind outlet of the air conditioner.

The lower wind outlet of the air conditioner, the second internal cavity and the second lower wind outlet form an outlet wind flow channel of the lower wind outlet of the air conditioner.

In an exemplary embodiment, the side of the first cover body is provided with a second wind outlet corresponding to the first wind outlet; the left and right sides of the second cover body are provided with the second upper wind outlet and the second lower wind outlet respectively; and the lower side of the second cover body is provided with the second wind inlet.

According to the second aspect, an embodiment of the present invention also provides a noise reduction method, which includes that:
a flow deflector is provided above a first ventilation opening on a front door of a cabinet;
a second ventilation opening corresponding to the first ventilation opening is also provided on the flow deflector, and the flow deflector cooperates with the front door of the cabinet to form a wind flow channel of the first ventilation opening, the ventilation openings being ventilation openings of a heat dissipation device in the cabinet; and
an acoustic absorption material is provided in the wind flow channel.

The beneficial effect of the embodiments of the present invention is as follows.

The embodiments of the present invention provide the noise reduction apparatus and method, which can effectively reduce noise generated by an outdoor cabinet with a heat dissipation device. Specifically, the noise reduction apparatus provided by the embodiment of the present invention includes the flow deflector. The flow deflector is provided above the first ventilation opening on the front door of the cabinet. The flow deflector is further provided thereon with the second ventilation opening corresponding to the first ventilation opening. The flow deflector cooperates with the front door of the cabinet to form the wind flow channel of the first ventilation opening. The ventilation openings are the ventilation openings of the heat dissipation device in the cabinet. The wind flow channel is provided therein with the acoustic absorption material. According to the embodiments of the present invention, the flow deflector is mounted on the front door of the cabinet to form the wind flow channel of the ventilation openings of the heat dissipation device, and inlet wind and outlet wind of the heat dissipation device are guided to flow in the wind flow channel. Moreover, the acoustic absorption material is provided on the wind flow channel, such that the noise generated by the heat dissipation device is absorbed by the acoustic absorption material in the wind flow channel to the greatest extent, thus reducing the noise of the cabinet. Compared with the existing art, the noise reduction apparatus provided by the embodiment of the present invention can reduce the noise of the cabinet in a severe environment, such that the noise level can meet a country level. Moreover, the apparatus provided by the embodiment of the present invention can reduce the noise without changing the own structure of the cabinet. The assembly of the apparatus is simple, and does not affect the appearance of the cabinet, and greatly meets demands of a user for noise control over the cabinet.

### Description of Drawings

FIG. 1 is a structural diagram of a first noise reduction apparatus assembled with a front door of a cabinet provided by embodiment 1 of the present invention.
FIG. 2 is a sectional view of sectioning FIG. 1 along a central axis direction provided by embodiment 1 of the present invention.
FIG. 3 is a structural diagram of a second noise reduction apparatus assembled with the front door of the cabinet provided by embodiment 1 of the present invention.
FIG. 4 is a sectional view of sectioning FIG. 3 along a central axis provided by embodiment 1 of the present invention.
FIG. 5 is a sectional view of sectioning a third noise reduction apparatus assembled with a front door of a cabinet along a central axis provided by embodiment 1 of the present invention.
FIG. 6 is a sectional view of sectioning a fourth noise reduction apparatus assembled with the front door of the cabinet along a central axis provided by embodiment 1 of the present invention.
FIG. 7 is a structural diagram of a noise reduction apparatus assembled with the front door of the cabinet provided by embodiment 2 of the present invention.
FIG. 8 is a sectional view of sectioning FIG. 7 along a central axis provided by embodiment 2 of the present invention.
FIG. 9 is a front schematic diagram of FIG. 8 provided by embodiment 2 of the present invention.
FIG. 10 is a schematic diagram of silencing the inlet wind of a TEC air conditioner and a heat exchanger provided by embodiment 2 of the present invention.
FIG. 11 is a schematic diagram of silencing the outlet wind of a TEC air conditioner provided by embodiment 2 of the present invention.

### Specific Embodiments

The technical solution of the embodiment of the present invention will be further elaborated below in specific implementation modes and in conjunction with accompanying drawings.

### Embodiment 1

In view of greater noise of outdoor cabinets with heat dissipation devices caused by running of the heat dissipation devices in the cabinets, there is no effective noise reduction apparatus for these cabinets at present, and the embodiment provides a noise reduction apparatus, applied to a cabinet with a heat dissipation device. A wind flow channel which may be used for silencing is formed above a ventilation opening of a front door of the cabinet, noise generated by the heat dissipation device is absorbed by using the wind flow channel, and therefore the noise of the cabinet is effectively reduced.

Specifically, the noise reduction apparatus of the embodiment includes a flow deflector. The flow deflector is provided above a first ventilation opening on a front door of a cabinet. The flow deflector is further provided thereon with a second ventilation opening corresponding to the first ventilation opening. The flow deflector cooperates with the front door of the cabinet to form a wind flow channel of the first ventilation opening. The ventilation openings are ventilation openings of a heat dissipation device in the cabinet. The wind flow channel is provided therein with an acoustic absorption material.

In the apparatus of the embodiment, the flow deflector may cooperate with the front door of the cabinet to form the wind flow channel of the ventilation opening of the heat dissipation device. Thus, both inlet wind and outlet wind of the heat dissipation device need to pass through the wind flow channel, thereby prolonging a noise transfer path of the heat dissipation device. Moreover, the acoustic absorption material is provided in the wind flow channel for absorbing noise generated by the heat dissipation device. The apparatus of the embodiment may provide inlet wind and/or outlet wind silencing paths for the heat dissipation device, and effectively reduces the noise of the cabinet without changing the own structure of the cabinet, such that the noise level of the cabinet may satisfy a country level.

In an exemplary embodiment, the flow deflector in the embodiment may include a cover body. The cover body is provided above the first ventilation opening. The cover body is provided with a second ventilation opening corresponding to the first ventilation opening. The cover body cooperates with the front door of the cabinet to form a cavity. The first ventilation opening, the second ventilation opening and the cavity form a wind flow channel of the ventilation openings. The inner side surface of the cover body is provided with an acoustic absorption material.

In the embodiment, the cover body may form the wind flow channel of the ventilation opening with the front door of the cabinet, such as an inlet wind channel of a wind inlet. Then, the inner side surface of the cover body is provided with the acoustic absorption material. When inlet and outlet wind flow pass through the wind flow channel, the acoustic absorption material on the inner side of the cover body may absorb the noise of the heat dissipation device. For example, when wind is output from the heat dissipation device, wind flow passes the acoustic absorption material in the channel first to be absorbed, and then is exhausted from the ventilation opening on the cover body, thereby achieving the effects of silencing the outlet wind of the heat dissipation device. The apparatus of the embodiment may construct the wind flow channel by using a simple structure namely the cover body, may be conveniently used by a user, and may save the cost.

A specific situation of noise reduction by the apparatus of the embodiment is introduced as follows.

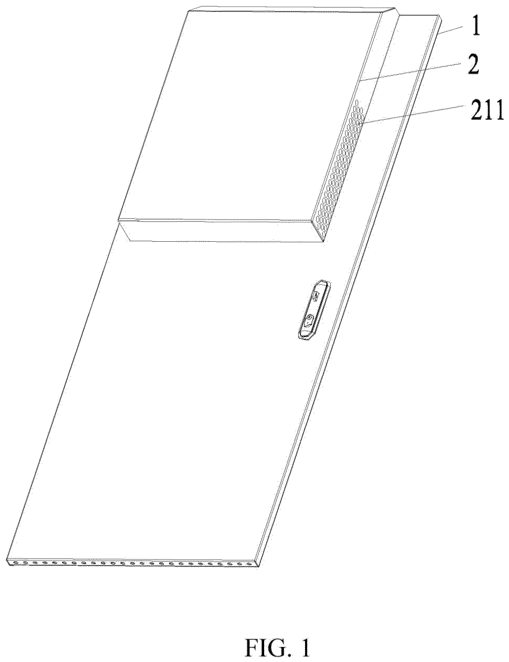

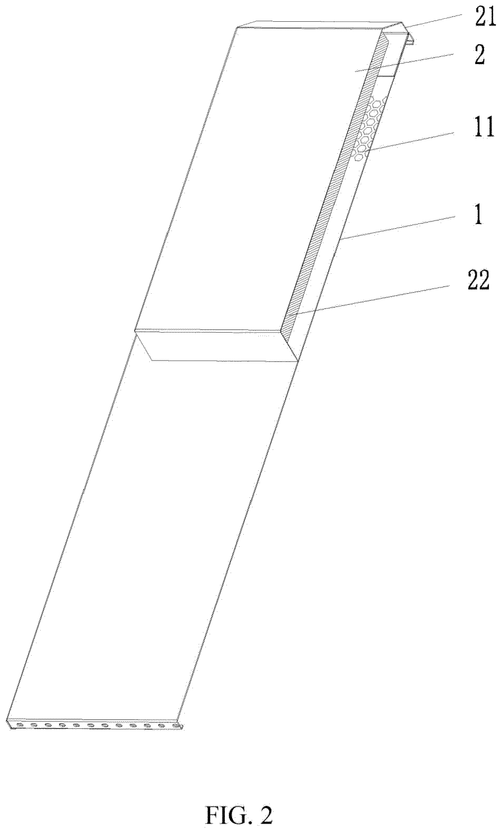

The ventilation opening on the front door of the cabinet in the embodiment may include: a wind inlet and/or wind outlet of a first heat dissipation device.
1. When the ventilation opening on the front door of the cabinet is the first wind outlet of the first heat dissipation device, the cover body is provided with a second wind outlet corresponding to the first wind outlet, and the first wind outlet, the second wind outlet and the cavity form an outlet wind flow channel of the first wind outlet.
   As shown in FIG. 1 and FIG. 2, the noise reduction apparatus includes an outlet wind silencing cover 2 of a heat exchanger, which is mounted above a heat exchanger wind outlet 11 on a front door 1 of a cabinet and communicated with the heat exchanger wind outlet 11 on the front door. The silencing cover 2 includes a cover body 21 and an acoustic absorption material 22. The inner side of the cover body 21 is provided with the acoustic absorption material 22. When the heat exchanger exhausts wind, airflow is exhausted from the wind outlet 11, and passes through the silencing cover 2, and is exhausted from a wind outlet 211 on the silencing cover 2. When wind flow is in the silencing cover 2, the acoustic absorption material 22 may absorb noise generated by the heat exchanger.
   The silencing principle of the apparatus of the embodiment is that: when the heat dissipation device exhausts wind, outlet wind airflow of the heat dissipation device passes the acoustic absorption material in the cover body first and the noise is absorbed, and then the outlet wind airflow is exhausted from the wind outlet on the cover body, thereby achieving the aim of silencing the outlet wind of the heat dissipation device.
2. When the ventilation opening on the front door of the cabinet is the first wind inlet of the first heat dissipation device, the cover body is provided with a second wind inlet corresponding to the first wind inlet, and the first wind inlet, the second wind inlet and the cavity form an inlet wind flow channel of the first wind inlet.
   Under the circumstance, the result of the noise reduction apparatus is similar to FIG. 1 and FIG. 2, and the noise reduction apparatus may refer to the structures shown in FIG. 1 and FIG. 2.
   The silencing principle of the apparatus of the embodiment is that: when the heat dissipation device sucks wind, air of an external environment is sucked from the wind inlet on the cover body, wind flow passes the acoustic absorption material in the wind channel first and the noise is absorbed, and then the wind flow enters the wind inlet of the heat dissipation device, thereby achieving the aim of silencing the inlet wind of the heat dissipation device.
3. When the ventilation opening on the front door of the cabinet is the first wind inlet and first wind outlet of the first heat dissipation device, namely a wind inlet/outlet of the same heat dissipation device, the cover body is provided with the second wind inlet corresponding to the first wind inlet, and the second wind inlet corresponding to the first wind inlet; and the first wind inlet, the second wind inlet and the cavity form an inlet wind flow channel of the first wind inlet; and the first wind outlet, the second wind outlet and the cavity form the inlet wind flow channel of the first wind inlet.

Under the circumstance, the structure of the noise reduction apparatus is similar to FIG. 1 and FIG. 2, for example, the silencing cover is located above the wind inlet/outlet of the heat dissipation device (e.g., heat exchanger), and when the device sucks and exhausts wind, wind flow will all pass through the silencing cover, and therefore the acoustic absorption material in the silencing cover may absorb noise generated by running of the device.

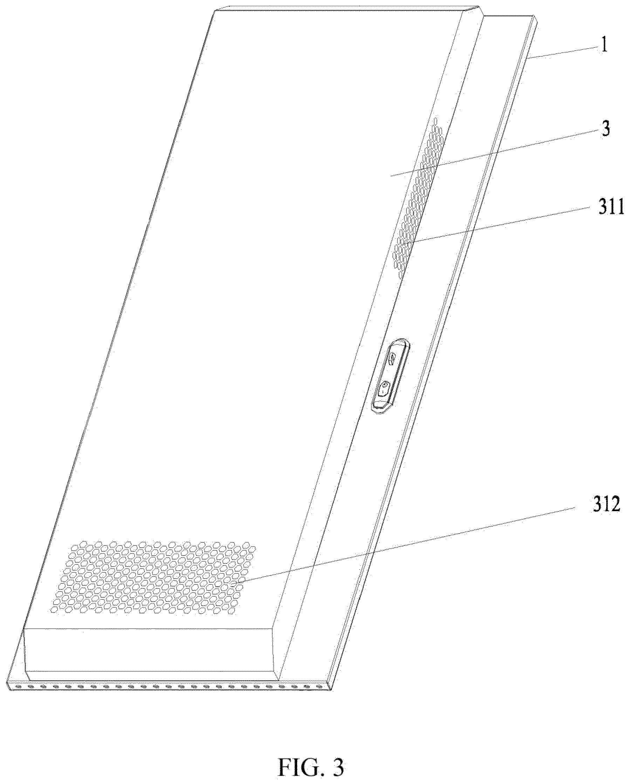

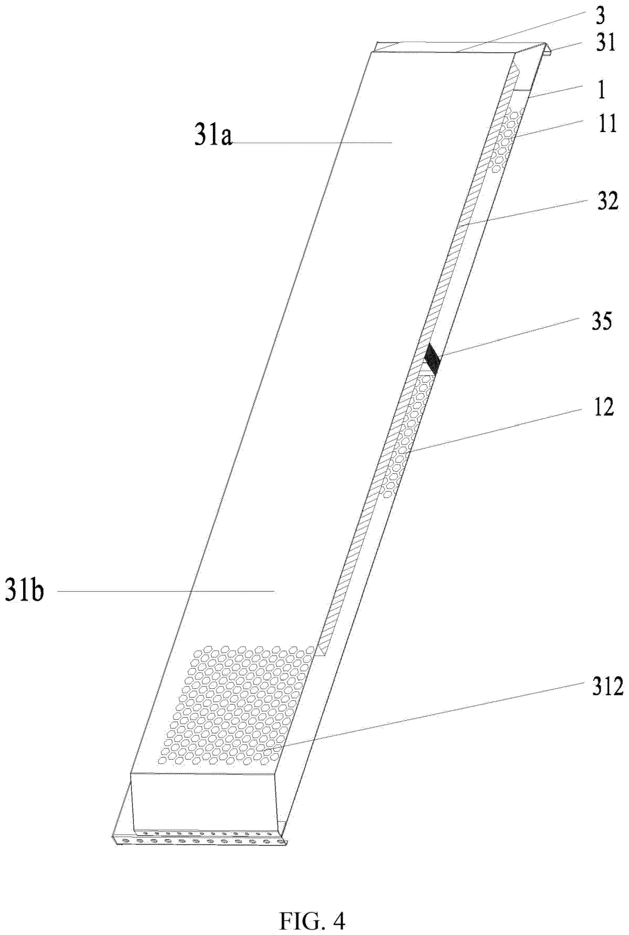

As shown in FIG. 3 and FIG. 4, the noise reduction apparatus includes an inlet/outlet wind silencing cover 3 of a heat exchanger, which is mounted above a wind outlet 11 and a wind inlet 12 on a front door 1 of a cabinet and communicated with the heat exchanger wind outlet 11 and wind inlet 12 on the front door respectively. A cover body 31 of the silencing cover 3 is isolated into an outlet wind silencing cover body 31a and an inlet wind silencing cover body 31b by an isolating sheet 35. The side of the outlet wind silencing cover body 31a is provided with a wind outlet 311 corresponding to the wind outlet 11, and the top of the inlet wind silencing cover body 31b is provided with a wind inlet 312 corresponding to the wind inlet 12. The inner side wall of the cover body 31 is provided thereon with an acoustic absorption material 32. When the heat exchanger exhausts wind, airflow passes through the acoustic absorption material 32 on the inner side of the outlet wind silencing cover body 31a and the noise is absorbed, and then the airflow is exhausted from the wind outlet 311, thereby achieving the aim of silencing the outlet wind of the heat exchanger. When the heat exchanger sucks wind, air of an external environment is sucked from the wind inlet 312 of the inlet wind silencing cover body 31b, and wind flow passes through the acoustic absorption material 32 on the inner side of the inlet wind silencing cover body 31b first and the noise is absorbed, and then the wind flow enters the wind inlet 12 of the heat dissipation device, thereby achieving the aim of silencing the inlet wind of the heat dissipation device.

The silencing principle of the apparatus of the embodiment is that: when the heat dissipation device exhausts wind, outlet wind airflow of the heat dissipation device passes through the acoustic absorption material in the cover body first and the noise is absorbed, and then the outlet wind airflow is exhausted from the wind outlet on the cover body, thereby achieving the aim of silencing the outlet wind of the heat dissipation device; and
when the heat dissipation device sucks wind, the air of the external environment is sucked from the wind inlet on the cover body, wind flow passes through the acoustic absorption material in the wind channel first and the noise is absorbed, and then the wind flow enters the wind inlet of the heat dissipation device, thereby achieving the aim of silencing the inlet wind of the heat dissipation device.

Under the circumstance, the aims of both silencing the outlet wind and silencing the inlet wind may be achieved simultaneously, thereby reducing the noise of the cabinet.

The first heat dissipation device in the embodiment may include: a heat exchanger, a TEC air conditioner, a compressor air conditioner or an air-heat integrated unit.

In another scenario, the first ventilation opening in the embodiment includes a first ventilation opening of a first heat dissipation device and a first ventilation opening of a second heat dissipation device, namely ventilation openings of different heat dissipation devices. Under the circumstance, in order to be capable of achieving the aim of silencing, the cover body in the embodiment includes a first cover body and a second cover body. The first cover body is provided above the first ventilation opening of the first heat dissipation device. The first cover body is provided with a second ventilation opening corresponding to the first ventilation opening of the first heat dissipation device. The first cover body and the front door of the cabinet form a first cavity. The first ventilation opening of the first heat dissipation device, the second ventilation opening on the first cover body and the first cavity form a wind flow channel of the first ventilation opening of the first heat dissipation device. The inner side of the first cover body is provided with an acoustic absorption material.

The second cover body is provided above the first ventilation opening of the second heat dissipation device. The second cover body is provided with a second ventilation opening corresponding to the first ventilation opening of the second heat dissipation device. The second cover body and the front door of the cabinet form a second cavity. The first ventilation opening of the second heat dissipation device, the second ventilation opening on the second cover body and the second cavity form a wind flow channel of the first ventilation opening of the second heat dissipation device.

The noise reduction apparatus of the embodiment may reduce noise for different heat dissipation devices. When ventilation openings on the front door of the cabinet are ventilation openings of two different heat dissipation devices, a cover body may be provided for each heat dissipation device to eliminate the noise of the heat dissipation device respectively. For example, when the front door of the cabinet is provided thereon with a wind outlet of a heat exchanger and a wind inlet/outlet of an air conditioner, in the embodiment, a cover body with a wind outlet may be provided above the wind outlet of the heat exchanger, and cooperates with the front door of the cabinet to form a wind flow channel of the wind outlet. When the heat exchanger exhausts wind, airflow is exhausted from the wind outlet on the front door of the cabinet, the airflow passes through an acoustic absorption material in the cover body first and the noise is absorbed, and then the airflow is exhausted from the wind outlet on the cover body. Meanwhile, a cover body with a wind inlet/outlet is provided above the wind inlet/outlet of the air conditioner, and cooperates with the front door of the cabinet to form a wind flow channel of the wind inlet/outlet. Thus, when the air conditioner exhausts wind or sucks wind, airflow will pass through an acoustic absorption material in the cover body first and the noise will be absorbed, and then the airflow is exhausted from the wind outlet on the cover body or sucked from the wind inlet of the air conditioner.

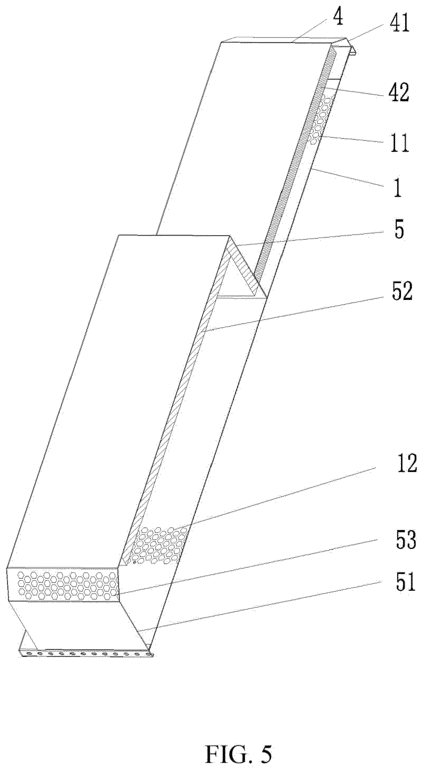

As shown in FIG. 5, the noise reduction apparatus includes an outlet wind silencing cover 4 of the first heat dissipation device and an inlet wind silencing cover 5 of the second heat dissipation device. The outlet wind silencing cover 4 is mounted above a wind outlet 11 of the first heat dissipation device on a front door 1 of a cabinet, and communicated with the wind outlet 11 of the first heat dissipation device on the front door. The outlet wind silencing cover 4 includes a cover body 41 and an acoustic absorption material 42. The inner side of the cover body 41 is provided with the acoustic absorption material 42. When the first heat dissipation device exhausts wind, airflow is exhausted from the wind outlet 11, and passes through the silencing cover 41 and is exhausted from the wind outlet (not shown in the figure) on the silencing cover 41. When wind flow is in the silencing cover 41, the acoustic absorption material 42 may absorb noise generated by a heat exchanger. The inlet wind silencing cover 5 of the second heat dissipation device is mounted above a wind inlet 12 of the second heat dissipation device on the front door 1 of the cabinet and communicated with the wind inlet 12. The inlet wind silencing cover 5 includes a cover body 51, an acoustic absorption material 52 on the inner side of the cover body 51, and a wind inlet 53 provided on the cover body 51. When the second heat dissipation device sucks wind, external airflow enters and passes through the cover body 51 from the wind inlet 52, the noise is absorbed by the acoustic absorption material 52 on the inner side of the cover body 51, and then the external airflow enters the second heat dissipation device from the wind inlet 12, thereby achieving the aim of silencing the inlet wind of the second heat dissipation device.

The noise reduction apparatus of the embodiment may be applied to a cabinet with two heat dissipation devices, thereby reducing the noise of the cabinet. Moreover, due to mutual isolation of wind channels of the two devices, airflow may be effectively prevented from being short-circuited, thereby improving the thermal design capability.

In another scenario, the noise reduction apparatus of the embodiment makes two heat dissipation devices share an outlet wind channel, such that the problem of space limitation of an existing cabinet may be solved, and the application range of the noise reduction apparatus is expanded. Specifically, the first ventilation opening in the embodiment includes: a first wind outlet and first wind inlet of the first heat dissipation device, and a ventilation opening of the second heat dissipation device. The cover body includes a first cover body and a second cover body. The first cover body is provided above the first wind inlet, and forms a first cavity with the front door of the cabinet, and the first cover body is provided with a second wind inlet corresponding to the first wind inlet; and the first wind inlet, the second wind inlet and the first cavity form an inlet wind flow channel of the first wind inlet.

The second cover body is provided above the first wind outlet and the ventilation opening of the second heat dissipation device. The second cover body and the front door of the cabinet form a second cavity. The second cover body is provided with a ventilation opening corresponding to the first wind outlet and the ventilation opening of the second heat dissipation device. The first wind outlet, the second cavity and the ventilation opening on the second cover body form an inlet wind flow channel of the first wind outlet. The ventilation opening of the second heat dissipation device, the second cavity and the ventilation opening on the second cover body form a wind flow channel of the ventilation opening of the second heat dissipation device.

Under the circumstance, the noise reduction apparatus may make the two heat dissipation devices share an outlet wind channel, thereby saving the cost.

In another scenario, the noise reduction apparatus of the embodiment makes two heat dissipation devices share an inlet wind channel. Specifically, the first ventilation opening includes: a first wind outlet and first wind inlet of the first heat dissipation device, and a ventilation opening of the second heat dissipation device. The cover body includes a first cover body and a second cover body. The first cover body is provided above the first wind outlet, and forms a first cavity with the front door of the cabinet. The first cover body is provided with a second wind outlet corresponding to the first wind outlet; and the first wind outlet, the second wind outlet and the first cavity form an outlet wind flow channel of the first wind outlet.

The second cover body is provided above the first wind inlet and the ventilation opening of the second heat dissipation device. The second cover body and the front door of the cabinet form a second cavity. The second cover body is provided with a ventilation opening corresponding to the first wind inlet and the ventilation opening of the second heat dissipation device. The first wind inlet, the second cavity and the ventilation opening on the second cover body form an inlet wind flow channel of the first wind inlet. The ventilation opening of the second heat dissipation device, the second cavity and the ventilation opening of the second cover body form a wind flow channel of the ventilation opening of the second heat dissipation device.

Under the circumstance, the wind inlet of the first heat dissipation device and the wind inlet/outlet of the second heat dissipation device share a wind channel to reduce noise.

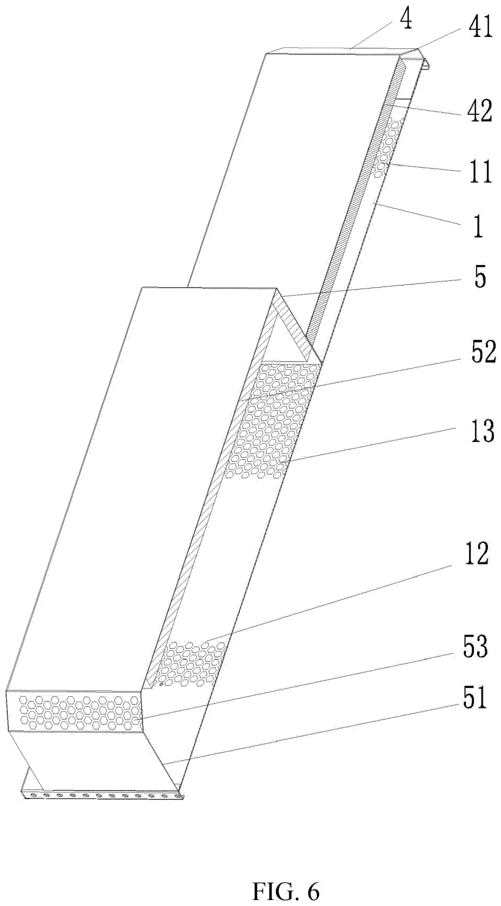

As shown in FIG. 6, on the basis of the abovementioned FIG. 5, a wind inlet 13 of the first heat dissipation device is further included. A wind inlet 13 and the wind inlet 12 share the silencing cover 5. When the first heat dissipation device and the second heat dissipation device suck wind, external airflow enters from the wind inlet 53 on the silencing cover 5, and passes through the acoustic absorption material 52 on the inner side of the silencing cover body 51 and the noise is absorbed, and then the external airflow enters the first heat dissipation device and the second heat dissipation device from the wind inlet 13 and the wind inlet 12 respectively, thereby finally achieving the aims of silencing the inlet wind of the first heat dissipation device and the second heat dissipation device.

### Embodiment 2

On the basis of sharing of a wind channel by the wind inlet of the first heat dissipation device and the wind inlet/outlet of the second heat dissipation device introduced in the abovementioned embodiment 1, in order to prevent the second heat dissipation device from airflow short-circuiting, the noise reduction apparatus of the embodiment may provide an isolator to isolate the cavity formed by the second cover body and the front door of the cabinet into two cavities, i.e., an internal cavity and an external cavity, for isolating an inlet/outlet wind channel of the second heat dissipation device from the inlet wind channel of the first heat dissipation device. Specifically, on the basis of the above, in the noise reduction apparatus of the embodiment, the cover body further includes an isolator located in the second cover body. The isolator is provided above the ventilation opening of the second heat dissipation device, and isolates the second cavity into two cavities, i.e., an internal cavity and an external cavity. The ventilation opening of the second heat dissipation device is located in the internal cavity, and the first wind inlet of the first heat dissipation device is located in the external cavity. The second cover body is provided with a second wind inlet corresponding to the first wind inlet, and a second ventilation opening corresponding to the ventilation opening of the second heat dissipation device.

The first wind inlet, the external cavity and the second wind inlet of the second cover body form an inlet wind flow channel of the first wind inlet.

The ventilation opening of the second heat dissipation device, the internal cavity and the ventilation opening on the second cover body, corresponding to the ventilation opening of the second heat dissipation device, form a wind flow channel of the ventilation opening of the second heat dissipation device, and the inner side of the internal cavity is provided with an acoustic absorption material.

The noise reduction apparatus of the embodiment may isolate the inlet/outlet wind channel of the second heat dissipation device, thereby preventing airflow from being short-circuited, and enhancing the effect of heat dissipation of the cabinet.

And when the second heat dissipation device is an air conditioner, that is, the ventilation opening of the second heat dissipation device includes: an inlet wind fan opening of the air conditioner and a wind outlet of the air conditioner. Since an air conditioner fan is provided on the front door of the cabinet, a wind inlet channel of the first heat dissipation device and a wind inlet/outlet channel of the second heat dissipation device may be isolated by providing a supporter to cooperate with the air conditioner fan during isolation of wind channels. Specifically, the ventilation opening of the second heat dissipation device includes: an inlet wind fan opening of an air conditioner and a wind outlet of the air conditioner. The isolator is a supporter, and the supporter cooperates with the inlet wind fan opening to isolate the second cavity into two cavities, i.e., an internal cavity and an external cavity. The first wind inlet is located in the external cavity, and the wind outlet of the air conditioner is located in the internal cavity, and the inlet wind fan opening is located at the top of the internal cavity. The second cover body is provided with a second wind inlet corresponding to the first wind inlet and the inlet wind fan opening, and the second cover body is further provided with a second wind outlet corresponding to the wind outlet of the air conditioner.

The first wind inlet, the external cavity and the second wind inlet of the second cover body form an inlet wind flow channel of the first wind inlet.

The inlet wind fan opening, the external cavity and the second wind inlet of the second cover body form an inlet wind flow channel of the inlet wind fan opening.

The wind outlet of the air conditioner, the internal cavity and the second wind outlet of the second cover body form an outlet wind flow channel of the wind outlet of the air conditioner, and the inner side of the supporter is provided with an acoustic absorption material.

In order to further enhance the effect of noise reduction, the embodiment may adopt an isolating sheet to isolate the internal cavity into a first internal cavity and a second internal cavity. Specifically, when the wind outlet of the air conditioner includes an upper wind outlet and a lower wind outlet, the flow deflector further includes an isolating sheet. The isolating sheet is located in the internal cavity and cooperates with the air conditioner to isolate the internal cavity into a first internal cavity and a second internal cavity. The upper wind outlet is located in the first internal cavity, and the lower wind outlet is located in the second internal cavity; and the second cover body is provided with a second upper wind outlet corresponding to the upper wind outlet and a second lower wind outlet corresponding to the lower wind outlet.

The upper wind outlet of the air conditioner, the first internal cavity and the second upper wind outlet form an outlet wind flow channel of the upper wind outlet of the air conditioner.

The lower wind outlet of the air conditioner, the second internal cavity and the second lower wind outlet form an outlet wind flow channel of the lower wind outlet of the air conditioner.

The noise reduction apparatus of the embodiment may isolate the internal cavity where the wind inlet/outlet of the air conditioner is located into two cavities, thereby mutually isolating airflows exhausted from an upper wind outlet and a lower wind outlet of the air conditioner, exhausting the airflows from different silencing cover wind outlet holes respectively, and enhancing the effect of silencing.

In an exemplary embodiment, the side of the abovementioned first cover body is provided with a second wind outlet corresponding to the first wind outlet; and the left and right sides of the second cover body are provided with the second upper wind outlet and the second lower wind outlet respectively; and the lower side of the second cover body is provided with the second wind inlet.

For example, the side surface of the first cover body may be provided with a wind outlet hole corresponding to the wind outlet of the first heat dissipation device, and the left and right sides of the second cover body, corresponding to the upper and lower wind outlets of the air conditioner, are provided with corresponding wind outlets; and besides, the lower side of the second cover body is provided with a wind inlet hole corresponding to the wind inlet of the first heat dissipation device.

In the embodiment, a rule of providing the wind inlet and outlet holes on the cover bodies is that: the wind channel is lengthened to the greatest extent, such that the acoustic absorption materials in the cover bodies may fully absorb noise, thereby enhancing the effect of noise reduction.

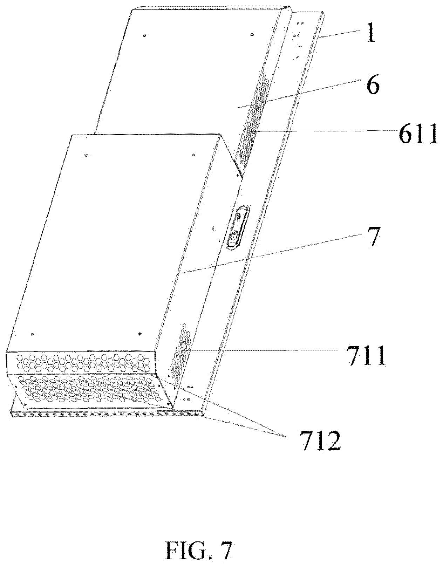

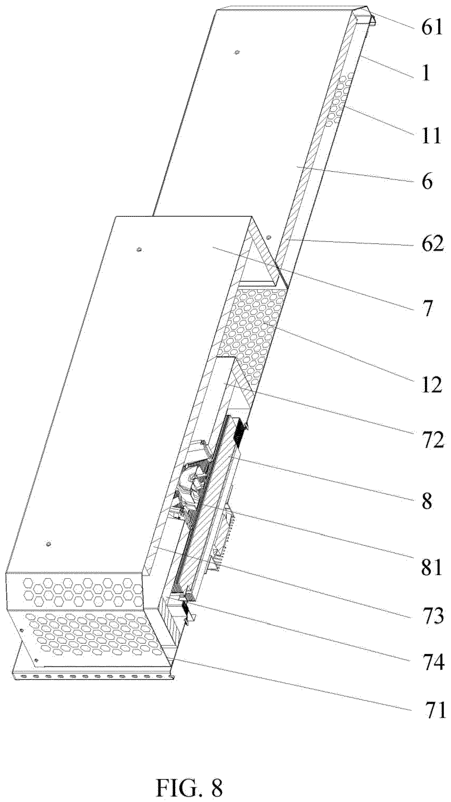

Referring to FIG. 7 to FIG. 11, the noise reduction apparatus in which the wind inlet of the first heat dissipation device and the wind inlet of the second heat dissipation device share a wind flow channel in the embodiment will be specifically introduced below with an example of the heat exchanger serving as the first heat dissipation device and the TEC air conditioner serving as the second heat dissipation device.

As shown in FIG. 7 to FIG. 11, the noise reduction apparatus of the embodiment includes: a heat exchanger outlet wind silencing cover 6 and an air-heat integrated silencing cover 7. The heat exchanger outlet wind silencing cover 6 is mounted on a front door 1 of the cabinet, and communicated with a heat exchanger wind outlet 11 on the front door to complete silencing of the heat exchanger wind outlet. The air-heat integrated silencing cover 7 is mounted on the door 1 of the cabinet, and communicated with a heat exchanger wind inlet 12 as well as with an inlet wind fan opening 81 and wind outlets 82 and 83 of the TEC air conditioner to complete silencing of inlet wind of the heat exchanger as well as silencing of inlet wind and outlet wind of the TEC air conditioner.

Specifically, a wind outlet 62 is provided on the side wall of the heat exchanger outlet wind silencing cover 6, and the heat exchanger outlet wind silencing cover 6 includes a cover body 61 and an acoustic absorption material 62, and the acoustic absorption material 62 of the heat exchanger outlet wind silencing cover 6 is stuck to the inner side of the cover body 61. The air-heat integrated silencing cover 7 includes a cover body 71, a supporter 72, and acoustic absorption materials 73 and 74. The acoustic absorption material 73 is stuck to the inner side of the cover body 71, and the acoustic absorption material 74 is stuck to the inner side of the supporter 72. Herein, the supporter 72 and the inlet wind fan opening 81 separate the cover body 71 into two cavities, i.e., an internal cavity and an external cavity, and a wind outlet of the air conditioner is located in the internal cavity, and a wind inlet of the heat exchanger is located in the external cavity.

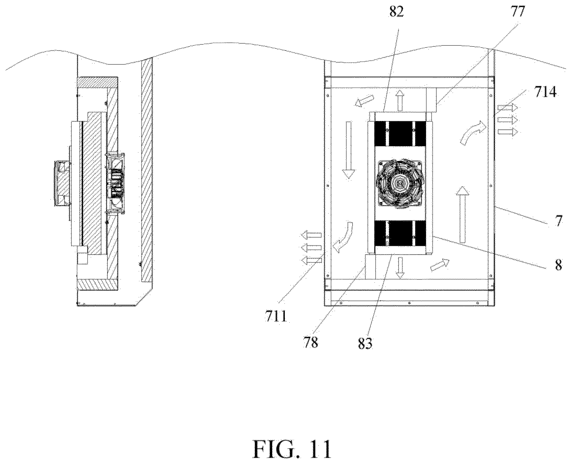

As shown in FIG. 7 and FIG. 11, a wind outlet 611 is located on the left side or right side of the cover body 61 of the heat exchanger outlet wind silencing cover 6. The two side surfaces of the cover body 71 of the air-heat integrated silencing cover 7 are provided with a wind outlet 711 and a wind outlet 713, and a wind inlet 712 is provided below the cover body 71.

The wind outlet 611 on the cover body 61, the cover body 61 and the heat exchanger wind outlet 11 form a wind flow channel of the heat exchanger wind outlet 11. The wind inlet 712, the external cavity of the cover body 71 and the air conditioner wind inlet 81 form an inlet wind flow channel of the air conditioner. The wind outlet 711, the internal cavity of the cover body 71 and the air conditioner wind outlets 82 and 83 form an outlet wind flow channel of the air conditioner.

It will be appreciated that the positions and area of the wind inlets and the wind outlets shown in FIG. 7 are not required to be constant. According to the requirements on ventilation quantity, the area and quantity of the wind inlets and the wind outlets may be adjusted, and according to the direction of the wind channel, the positions of the wind inlets and the wind outlets may also be adjusted. The rule is that the wind channel is lengthened to the greatest extent and a silencing material in the wind channel is utilized to the greatest extent to reduce noise. The embodiment of the present invention is not just limited to the abovementioned forms.

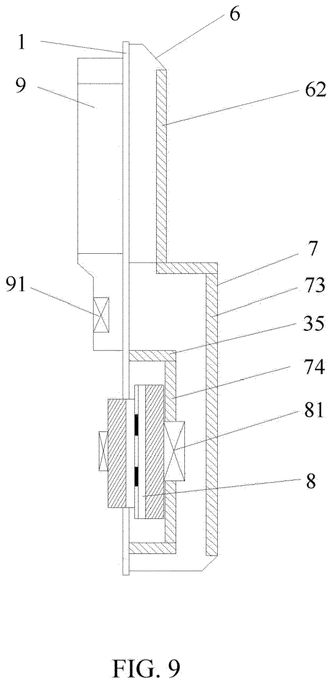

As shown in FIG. 9, a side sectional view after the heat exchanger silencing cover 6 and the air-heat integrated silencing cover 7 are mounted on the front door 1 is shown. A heat exchanger 9 and a TEC air conditioner 8 are fixed on the upper and lower part of the front door 1. The heat exchanger includes an external circulating fan 91. The heat exchanger outlet wind silencing cover 6 is fixed on the front door 1 and corresponds to the heat exchanger wind outlet 11. The air-heat integrated silencing cover 7 is fixed on the front door and corresponds to the TEC air conditioner 8 and the heat exchanger wind inlet 12.

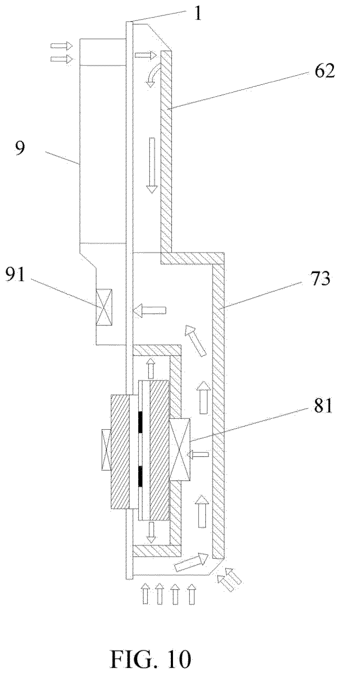

As shown in FIG. 10, a noise reduction principle of the noise reduction apparatus of the embodiment is introduced. Firstly, an inlet wind path of heat exchanger external circulation is that: wind flow enters the air-heat integrated silencing cover 7 via a wind inlet 712, and passes through the acoustic absorption material 73 and the noise is absorbed, and then the wind flow enters a heat exchanger inlet wind fan 91. An outlet wind path of heat exchanger external circulation is that: wind flow from the heat exchanger wind outlet 11 passes through the acoustic absorption material 62 and the noise is absorbed, and then the wind flow is exhausted from a wind outlet 611. An inlet wind path of TEC air conditioner external circulation is that: wind flow enters the air-heat integrated silencing cover 7 via the wind inlet 712, and passes through the acoustic absorption material 73 and the noise is absorbed, and then the wind flow enters the inlet wind fan opening 81 of the air conditioner.

As shown in FIG. 11, the air-heat integrated silencing cover 7, the TEC air conditioner 8, an acoustic absorption material 74 and isolating sheets 77 and 78 provided with acoustic absorption materials and the front door jointly form two independent cavities namely a left cavity and a right cavity, and the two cavities are communicated with an upper wind outlet 82 and a lower wind outlet 83 of the TEC air conditioner respectively. An outlet wind path of TEC air conditioner external circulation is that: wind flow is exhausted from the upper wind outlet 82 and lower wind outlet 83 of the TEC air conditioner respectively, and passes through the acoustic absorption material 74 stuck to the inner side of the supporter 72 and the noise is absorbed, and then the wind flow is exhausted from the wind outlet 711 and the wind outlet 714 on the two sides of the air-heat integrated silencing cover.

Compared with the existing art, the noise reduction apparatus of the embodiment has the following characteristics.
(1) The heat exchanger and the TEC air conditioner share the same inlet wind channel, thereby solving the problem of space limitation of the existing cabinet.
(2) The inlet wind channel and the outlet wind channel are isolated, thereby effectively preventing airflow from being short-circuited, and improving the thermal design capability.
(3) The paths of all inlet and outlet wind channels are designed in an encircling form, such that it can be ensured that noise of inlet wind airflow and outlet wind airflow is absorbed by the acoustic absorption material to the greatest extent.
(4) The noise level of the cabinet is a city level originally, without changing the own structure of the cabinet, a noise value measured is less than 67dB after the apparatus is adopted, such that country-level use demands are met, and the effect of silencing is enhanced.

### Embodiment 3

The embodiment provides a noise reduction method, which includes that:
a flow deflector is provided above a first ventilation opening on a front door of a cabinet;
a second ventilation opening corresponding to the first ventilation opening is provided on the flow deflector, and the flow deflector cooperates with the front door of the cabinet to form a wind flow channel of the first ventilation opening, and the ventilation openings are ventilation openings of a heat dissipation device in the cabinet; and
an acoustic absorption material is provided in the wind flow channel.

According to the method of the embodiment, the flow deflector is mounted on the front door of the cabinet to form the wind flow channel of the ventilation openings of the heat dissipation device, and inlet wind and outlet wind of the heat dissipation device are guided to flow in the wind flow channel. Moreover, the acoustic absorption material is provided on the wind flow channel, such that the noise generated by the heat dissipation device is absorbed by the acoustic absorption material in the wind flow channel to the greatest extent, thus reducing the noise of the cabinet. Compared with the existing art, the method of the embodiment may reduce the noise of the cabinet in a severe environment, such that the noise level may meet a country level. Moreover, the method of the embodiment of the present invention may reduce the noise without changing the own structure of the cabinet. The assembly of the method is simple, and the method does not affect the appearance of the cabinet, and greatly meets demands of a user for noise control of the cabinet.

The above contents are further detailed descriptions made for the technical solution of the present invention in conjunction with specific implementation modes. It cannot be considered that specific implementations of the present invention are only limited to these descriptions. Those ordinarily skilled in the technical art, within which the present invention falls, may also make several simple deductions or replacements without departing from the concept of the present invention. These simple deductions or replacements should be regarded as falling within the scope of protection of the present invention.

### Industrial Applicability

In the embodiments of the present invention, the noise reduction apparatus includes a flow deflector, and the flow deflector is provided above a first ventilation opening on a front door of a cabinet. The flow deflector is further provided thereon with a second ventilation opening corresponding to the first ventilation opening. The flow deflector cooperates with the front door of the cabinet to form a wind flow channel of the first ventilation opening. The ventilation openings are ventilation openings of a heat dissipation device in the cabinet. The wind flow channel is provided therein with an acoustic absorption material. Thus, the technical solution provided by the embodiments of the present invention may effectively reduce noise generated by an outdoor cabinet with a heat dissipation device.

## Claims

1. A noise reduction apparatus, comprising a flow deflector, wherein the flow deflector is provided above a first ventilation opening on a front door of a cabinet, and the flow deflector is further provided thereon with a second ventilation opening corresponding to the first ventilation opening, and the flow deflector cooperates with the front door of the cabinet to form a wind flow channel of the first ventilation opening; the ventilation openings are ventilation openings of a heat dissipation device in the cabinet, and the wind flow channel is provided therein with an acoustic absorption material.

2. The apparatus according to claim 1, wherein the flow deflector comprises a cover body, and the cover body is provided above the first ventilation opening, and the cover body is provided with the second ventilation opening corresponding to the first ventilation opening, and the cover body cooperates with the front door of the cabinet to form a cavity; the first ventilation opening, the second ventilation opening and the cavity form a wind flow channel of the ventilation openings, and an inner side surface of the cover body is provided with an acoustic absorption material.

3. The apparatus according to claim 2, wherein the first ventilation opening comprises a first wind outlet of a first heat dissipation device; the cover body is provided with a second wind outlet corresponding to the first wind outlet, and the first wind outlet, the second wind outlet and the cavity form an outlet wind flow channel of the first wind outlet;
or,
the first ventilation opening comprises a first wind inlet of the first heat dissipation device; the cover body is provided with a second wind inlet corresponding to the first wind inlet, and the first wind inlet, the second wind inlet and the cavity form an inlet wind flow channel of the first wind inlet;
or,
the first ventilation opening comprises the first wind inlet and first wind outlet of the first heat dissipation device; the cover body is provided with the second wind inlet corresponding to the first wind inlet, and the second wind inlet corresponding to the first wind inlet; the first wind inlet, the second wind inlet and the cavity form an inlet wind flow channel of the first wind inlet, and the first wind outlet, the second wind outlet and the cavity form the inlet wind flow channel of the first wind inlet.

4. The apparatus according to claim 2, wherein the first ventilation opening comprises a first ventilation opening of the first heat dissipation device and a first ventilation opening of a second heat dissipation device; the cover body comprises a first cover body and a second cover body; the first cover body is provided above the first ventilation opening of the first heat dissipation device, and the first cover body is provided with a second ventilation opening corresponding to the first ventilation opening of the first heat dissipation device, and the first cover body and the front door of the cabinet form a first cavity; the first ventilation opening of the first heat dissipation device, the second ventilation opening on the first cover body and the first cavity form a wind flow channel of the first ventilation opening of the first heat dissipation device, and an inner side of the first cover body is provided with an acoustic absorption material; and
the second cover body is provided above the first ventilation opening of the second heat dissipation device, and the second cover body is provided with a second ventilation opening corresponding to the first ventilation opening of the second heat dissipation device, and the second cover body and the front door of the cabinet form a second cavity; the first ventilation opening of the second heat dissipation device, the second ventilation opening on the second cover body and the second cavity form a wind flow channel of the first ventilation opening of the second heat dissipation device.

5. The apparatus according to claim 2, wherein the first ventilation opening comprises: a first wind outlet and first wind inlet of the first heat dissipation device, and a ventilation opening of the second heat dissipation device; the cover body comprises a first cover body and a second cover body; the first cover body is provided above the first wind inlet and forms a first cavity with the front door of the cabinet, and the first cover body is provided with a second wind inlet corresponding to the first wind inlet; and the first wind inlet, the second wind inlet and the first cavity form an inlet wind flow channel of the first wind inlet; and
the second cover body is provided above the first wind outlet and the ventilation opening of the second heat dissipation device, and the second cover body and the front door of the cabinet form a second cavity, and the second cover body is provided with a ventilation opening corresponding to the first wind outlet and the ventilation opening of the second heat dissipation device; the first wind outlet, the second cavity and the ventilation opening on the second cover body form an inlet wind flow channel of the first wind outlet, and the ventilation opening of the second heat dissipation device, the second cavity and the ventilation opening on the second cover body form a wind flow channel of the ventilation opening of the second heat dissipation device.

6. The apparatus according to claim 2, wherein the first ventilation opening comprises: a first wind outlet and first wind inlet of the first heat dissipation device, and a ventilation opening of the second heat dissipation device; the cover body comprises a first cover body and a second cover body; the first cover body is provided above the first wind outlet and forms a first cavity with the front door of the cabinet, and the first cover body is provided with a second wind outlet corresponding to the first wind outlet; and the first wind outlet, the second wind outlet and the first cavity form an outlet wind flow channel of the first wind outlet; and
the second cover body is provided above the first wind inlet and the ventilation opening of the second heat dissipation device, and the second cover body and the front door of the cabinet form a second cavity, and the second cover body is provided with a ventilation opening corresponding to the first wind inlet and the ventilation opening of the second heat dissipation device; the first wind inlet, the second cavity and the ventilation opening on the second cover body form an inlet wind flow channel of the first wind inlet, and the ventilation opening of the second heat dissipation device, the second cavity and the ventilation opening of the second cover body form a wind flow channel of the ventilation opening of the second heat dissipation device.

7. The apparatus according to claim 6, wherein the cover body further comprises an isolator located in the second cover body, and the isolator is provided above the ventilation opening of the second heat dissipation device and isolates the second cavity into two cavities, i.e., an internal cavity and an external cavity, and the ventilation opening of the second heat dissipation device is located in the internal cavity, and the first wind inlet of the first heat dissipation device is located in the external cavity; the second cover body is provided with a second wind inlet corresponding to the first wind inlet, and a second ventilation opening corresponding to the ventilation opening of the second heat dissipation device;
the first wind inlet, the external cavity and the second wind inlet of the second cover body form an inlet wind flow channel of the first wind inlet; and
the ventilation opening of the second heat dissipation device, the internal cavity and the ventilation opening, corresponding to the ventilation opening of the second heat dissipation device, on the second cover body form a wind flow channel of the ventilation opening of the second heat dissipation device; and the inner side of the internal cavity is provided with an acoustic absorption material.

8. The apparatus according to claim 7, wherein the ventilation opening of the second heat dissipation device comprises: an inlet wind fan opening of an air conditioner and a wind outlet of the air conditioner; the isolator is a supporter, and the supporter cooperates with the inlet wind fan opening to isolate the second cavity into two cavities, i.e., an internal cavity and an external cavity; the first wind inlet is located in the external cavity, and the wind outlet of the air conditioner is located in the internal cavity, and the inlet wind fan opening is located at the top of the internal cavity; the second cover body is provided with a second wind inlet corresponding to the first wind inlet and the inlet wind fan opening, and the second cover body is further provided with a second wind outlet corresponding to the wind outlet of the air conditioner;
the first wind inlet, the external cavity and the second wind inlet of the second cover body form an inlet wind flow channel of the first wind inlet;
the inlet wind fan opening, the external cavity and the second wind inlet of the second cover body form an inlet wind flow channel of the inlet wind fan opening; and
the wind outlet of the air conditioner, the internal cavity and the second wind outlet of the second cover body form an outlet wind flow channel of the wind outlet of the air conditioner; and an inner side of the supporter is provided with an acoustic absorption material.

9. The apparatus according to claim 8, wherein the wind outlet of the air conditioner comprises an upper wind outlet and a lower wind outlet; the flow deflector further comprises an isolating sheet; the isolating sheet is located in the internal cavity and cooperates with the air conditioner to isolate the internal cavity into a first internal cavity and a second internal cavity; the upper wind outlet is located in the first internal cavity, and the lower wind outlet is located in the second internal cavity; and the second cover body is provided with a second upper wind outlet corresponding to the upper wind outlet and a second lower wind outlet corresponding to the lower wind outlet;
the upper wind outlet of the air conditioner, the first internal cavity and the second upper wind outlet form an outlet wind flow channel of the upper wind outlet of the air conditioner; and
the lower wind outlet of the air conditioner, the second internal cavity and the second lower wind outlet form an outlet wind flow channel of the lower wind outlet of the air conditioner.

10. The apparatus according to claim 9, wherein the side of the first cover body is provided with a second wind outlet corresponding to the first wind outlet; the left and right sides of the second cover body are provided with the second upper wind outlet and the second lower wind outlet respectively, and the lower side of the second cover body is provided with the second wind inlet.

11. A noise reduction method, comprising:
providing a flow deflector above a first ventilation opening on a front door of a cabinet;
providing a second ventilation opening corresponding to the first ventilation opening on the flow deflector; and cooperating, by the flow deflector, with the front door of the cabinet to form a wind flow channel of the first ventilation opening; and the ventilation openings being ventilation openings of a heat dissipation device in the cabinet; and
providing an acoustic absorption material in the wind flow channel.
